# EUROPEAN PATENT APPLICATION

(11) **EP 4 682 692 A1**
(43) Date of publication of application: **21.01.2026**
(21) Application number: 25189820.1
(22) Date of filing: 16.07.2025
(51) Int. Cl.: G06F 3/041, G06F 3/044

(54) **DISPLAY DEVICE AND ELECTRONIC DEVICE COMPRISING SAME**

(30) Priority: 17.07.2024 KR 20240094516
(71) Applicant: Samsung Display Co., Ltd., Yongin-si, Gyeonggi-do 17113 (KR)
(72) Inventor: SONG, Bo Kwang, 17113 Yongin-si (KR); KIM, Gee Bum, 17113 Yongin-si (KR); BAE, Kwang Soo, 17113 Yongin-si (KR); CHOI, Min Oh, 17113 Yongin-si (KR); HONG, Soo Yeong, 17113 Yongin-si (KR)
(74) Representative: Taor, Simon Edward William

(57) **Abstract**

A display device may include a sub-pixel above a base layer, and including a light-emitting element, a light-sensing pixel above the base layer, and including a light-receiving element configured to acquire a sensing signal corresponding to light emitted from the light-emitting element, and a touch sensor layer configured to acquire information about a touch input, and including a conductive pattern layer forming sensing electrodes and including a second conductive pattern layer including a body portion enclosing the light-receiving element in plan view, and arm portions extending from the body portion in respective directions, and a first conductive pattern layer in a different layer from the second conductive pattern layer, and including segments apart from each other in respective areas between respective ones of the arm portions in plan view.

## Description

### CROSS-REFERENCE TO RELATED APPLICATION

The present application claims priority to, and the benefit of, Korean Patent Application No. 10-2024-0094516, filed on July 17, 2024, in the Korean Intellectual Property Office.

### BACKGROUND

### 1. Field

Various embodiments of the present disclosure relate to a display device, and to an electronic device including the display device.

### 2. Description of Related Art

With advancement in information-oriented societies, requirements for display devices configured to display an image have increased in various types. Recently, research and development have been conducted on technology that integrates a sensor for recognizing input information, such as a fingerprint, into at least a portion of a display panel that covers a large area of the display device.

### SUMMARY

An aspect of the present disclosure are directed to a display device, and to an electronic device including the display device, in which light-sensing pixels can have improved light-sensing performance, thereby making it possible to clearly detect external inputs.

An aspect of the present disclosure is directed to a display device having improved viewing angle characteristics, and to an electronic device including the display device.

An aspect of the present disclosure is directed to a display device having improved touch sensitivity, and an electronic device including the display device.

One or more embodiments of the present disclosure may provide a display device, including a sub-pixel above a base layer, and including a light-emitting element, a light-sensing pixel above the base layer, and including a light-receiving element configured to acquire a sensing signal corresponding to light emitted from the light-emitting element, and a touch sensor layer configured to acquire information about a touch input, and including a conductive pattern layer forming sensing electrodes and including a second conductive pattern layer including a body portion enclosing the light-receiving element in plan view, and arm portions extending from the body portion in respective directions, and a first conductive pattern layer in a different layer from the second conductive pattern layer, and including segments apart from each other in respective areas between respective ones of the arm portions in plan view.

The display device may further include a sensing area with the sensing electrodes therein, a display area with the sub-pixel therein, including an emission area, and overlapping the sensing area, and a fingerprint-sensing area with the light-sensing pixel therein, including a light-receiving area, and overlapping the display area.

The second conductive pattern layer may include a hole area overlapping the light-receiving area.

The segments may be around a periphery of the second conductive pattern layer, and may be apart from the hole area and the light-receiving area in plan view.

One of the segments may be between the emission area and the second conductive pattern layer in plan view, and may be in a loop structure of the second conductive pattern layer that encloses the emission area.

The first conductive pattern layer may include an emission-facing end facing the emission area, and defining a range of a light output path of light emitted from the light-emitting element, and an optical-facing end facing the light-receiving area.

The emission-facing end may define a range of an external light path for external light applied from outside of the display device.

The light output path may have a first interfacial angle with respect to a thickness direction of the base layer that has a maximum value when the light output path is directly adjacent to the emission-facing end, wherein the external light path has a second interfacial angle with respect to the thickness direction that has a maximum value when the external light path is directly adjacent to the emission-facing end.

The second interfacial angle may be greater than the first interfacial angle.

The optical-facing end and the second conductive pattern layer may be apart in plan view.

The optical-facing end and one end of the second conductive pattern layer may be aligned.

The first conductive pattern layer and the second conductive pattern layer may overlap, and may be electrically insulated from each other.

The first conductive pattern layer and the second conductive pattern layer may overlap, and may be electrically connected to each other.

The first conductive pattern layer and the second conductive pattern layer may be apart in plan view.

The segments may include electrically floating isolated portions.

The light-receiving element may include a light-receiving layer, wherein the light-emitting element includes an emission layer, wherein the touch sensor layer includes a sensor base layer including a base with the first conductive pattern layer thereabove, and an intermediate insulating layer between the first conductive pattern layer and the second conductive pattern layer, wherein the display device further includes a pixel-defining layer covering a portion of the light-receiving layer and a portion of the emission layer, and an encapsulation layer covering the light-receiving element and the light-emitting element, and with the sensor base layer directly thereon.

One or more embodiments of the present disclosure may provide a display device, including a sub-pixel above a base layer, and including a light-emitting element, a light-sensing pixel above the base layer, and including a light-receiving element configured to acquire a sensing signal corresponding to light emitted from the light-emitting element, and a touch sensor layer configured to acquire information about a touch input, and including a conductive pattern layer forming sensing electrodes and including a first conductive pattern layer, a second conductive pattern layer having a portion forming a hole area overlapping the light-receiving element, and another portion forming a sidewall, and an intermediate insulating layer between the first conductive pattern layer and the second conductive pattern layer, and having a first thickness in a first area that overlaps the hole area, and a second thickness that is less than the first thickness in a second area, wherein the sidewall is between the first area and the second area.

The first conductive pattern layer may be not around a periphery of the hole area.

The second conductive pattern layer may include an upper component above the intermediate insulating layer having the first thickness in the first area, and a lower component above the intermediate insulating layer having the second thickness in the second area, wherein the sidewall is between the lower component and the upper component.

One or more embodiments of the present disclosure may provide an electronic device including a processor configured to provide input image data, a power supply configured to supply power, a display device configured to receive the power, and to display an image based on the input image data, and including a sub-pixel including a light-emitting element, a light-sensing pixel including a light-receiving element configured to acquire a sensing signal corresponding to light emitted from the light-emitting element, and a touch sensor layer configured to acquire information about a touch input, and including a conductive pattern layer forming sensing electrodes and including a second conductive pattern layer including a body portion enclosing the light-receiving element in plan view, and arm portions extending from the body portion in respective directions, and a first conductive pattern layer in a different layer than the second conductive pattern layer, and including segments apart from each other and in respective areas between respective ones of the arm portions in plan view.

The electronic device may include a smartphone, a television, a monitor, a tablet, an electric vehicle, a mobile phone, a tablet personal computer (PC), a mobile communication terminal, an electronic notebook, an electronic book, a portable multimedia player (PMP), a navigation device, an ultra-mobile PC (UMPC), a laptop computer, a billboard, an Internet of Things (IoT) device, a smartwatch, a watch phone, or a head-mounted display (HMD).

According to an aspect, there is provided a display device as set out in claim 1. Additional features are set out in claims 2 to 11. According to an aspect, there is provided a display device as set out in claim 12. Additional features are set out in claims 13 and 14. According to an aspect, there is provided an electronic device as set out in claim 15.

### BRIEF DESCRIPTION OF THE DRAWINGS

FIG. 1 is a schematic sectional view illustrating a display device in accordance with one or more embodiments.
FIGS. 2 and 3 are schematic plan views illustrating the display device in accordance with one or more embodiments.
FIG. 4 is a schematic sectional view illustrating a display panel in accordance with one or more embodiments.
FIG. 5 is a schematic sectional view illustrating a touch sensor layer in accordance with one or more embodiments.
FIG. 6 is a schematic plan view illustrating sensing electrodes in accordance with one or more embodiments.
FIG. 7 is a schematic sectional view illustrating the touch sensor layer in accordance with one or more embodiments.
FIGS. 8 and 9 are schematic plan views illustrating a portion of a display area including a fingerprint-sensing area in a display device in accordance with one or more embodiments.
FIG. 10 is a schematic sectional view taken along the line C-C' of FIGS. 8 and 9.
FIGS. 11 to 14 are schematic sectional views taken along the line D-D' of FIGS. 8 and 9.
FIGS. 15 and 16 are schematic enlarged views of area EA1 of FIG. 9.
FIG. 17 is a schematic plan view illustrating a portion of a display area including a fingerprint-sensing area in a display device in accordance with one or more embodiments.
FIG. 18 is a schematic sectional view taken along the line E-E' of FIG. 17.
FIG. 19 is a schematic block diagram illustrating an electronic device including the display device in accordance with one or more embodiments.
FIG. 20 is a schematic diagram illustrating an example where the electronic device of FIG. 19 is implemented as a smartphone.
FIG. 21 is a schematic diagram illustrating an example where the electronic device of FIG. 19 is implemented as a tablet PC.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, embodiments of the disclosure are not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Various embodiments of the present disclosure relate to a display device and an electronic device including the display device. Hereinafter, a display device and an electronic device including the display device in accordance with one or more embodiments will be described with reference to the attached drawings.

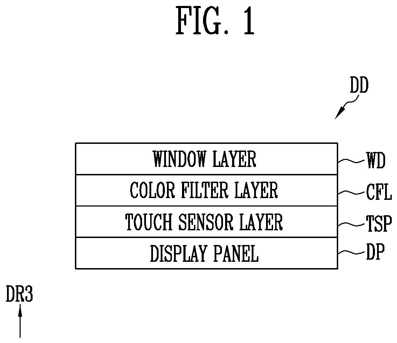

Hereinafter, a display device DD in accordance with one or more embodiments will be described with reference to FIGS. 1 to 7.

FIG. 1 is a schematic sectional view illustrating the display device DD in accordance with one or more embodiments.

Referring to FIG. 1, the display device DD is configured to provide light. The display device DD may include a display panel DP and a touch sensor layer TSP. In one or more embodiments, the display device DD may further include a color filter layer CFL and a window layer WD.

The display panel DP may display visual information. The display panel DP may include various light sources capable of providing light. For example, the display panel DP may include an organic light-emitting diode.

The touch sensor layer TSP may be directly on the display panel DP, or may be located on the display panel DP with a separate layer, such as an adhesive layer or a substrate (or an insulating layer) interposed therebetween (as used herein, "located on" may mean "above").

The touch sensor layer TSP may be located on an image display surface of the display panel DP, and may be configured to receive a touch input from a user. The touch sensor layer TSP may acquire information about the touch input. The touch sensor layer TSP may recognize a touch event of the display device DD through the hand of the user or a separate input unit. The touch sensor layer TSP may recognize the touch event using a capacitance method.

The touch sensor layer TSP may sense touch inputs using a mutual capacitance method, or may sense touch inputs using a self-capacitance method.

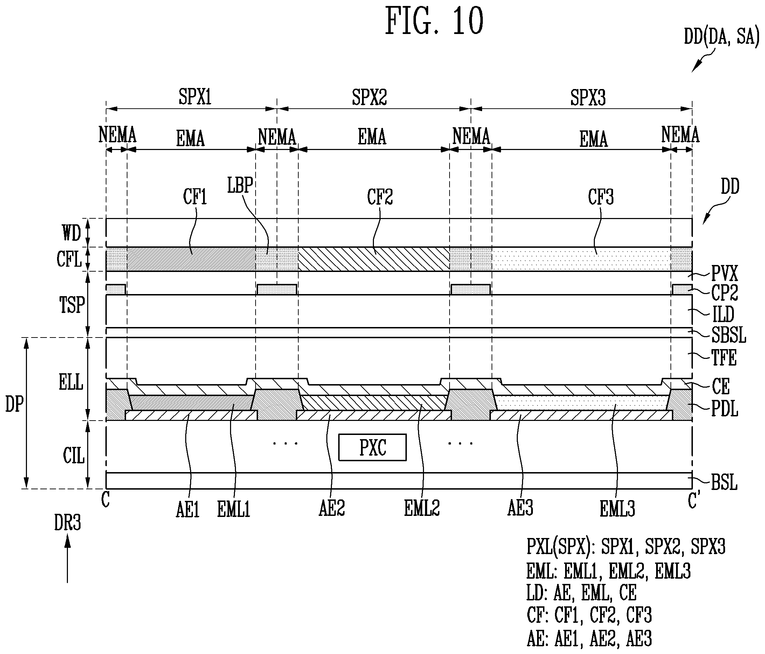

The color filter layer CFL may be located on the touch sensor layer TSP. The color filter layer CFL may include color filters CF (refer to FIG. 10) each of which selectively transmits light of a corresponding color, and includes a dye or pigment. The window layer WD may be located on the color filter layer CFL. The window layer WD may protect the underlying layers from external impacts, and may provide an input surface and/or a display surface for the user. The window layer WD may transmit light. The window layer WD may be bonded to the color filter layer CFL by various methods, such as using an adhesive layer.

The display device DD according to one or more embodiments is a device that displays a moving image and/or a still image. The display device DD may be applied to portable electronic devices, such as mobile phones, smartphones, tablet personal computers (PCs), mobile communication terminals, electronic notebooks, electronic books, portable multimedia players (PMPs), navigations, and ultra-mobile PCs (UMPCs). For example, the display device DD may be applied to a display unit of a television, a laptop computer, a monitor, a billboard, or the Internet of Things (IoT) device. Alternatively, in one or more embodiments, the display device DD may be applied to a smartwatch, a watch phone, and/or a head-mounted display device (HMD) for implementing virtual reality and/or augmented reality.

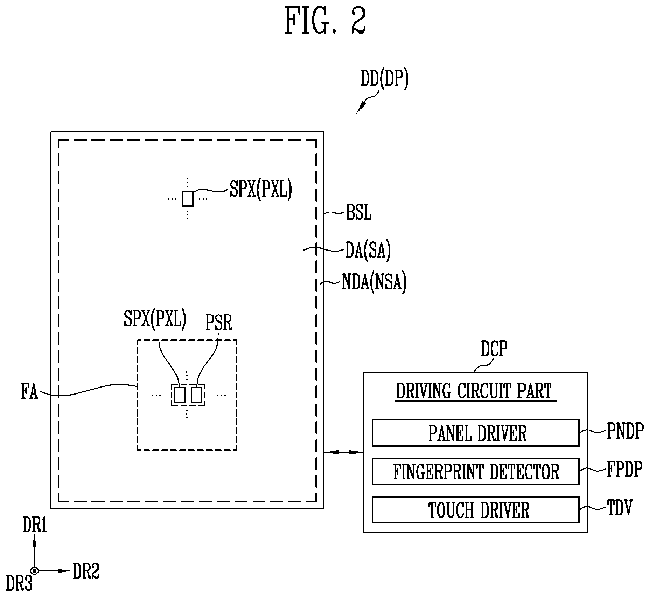

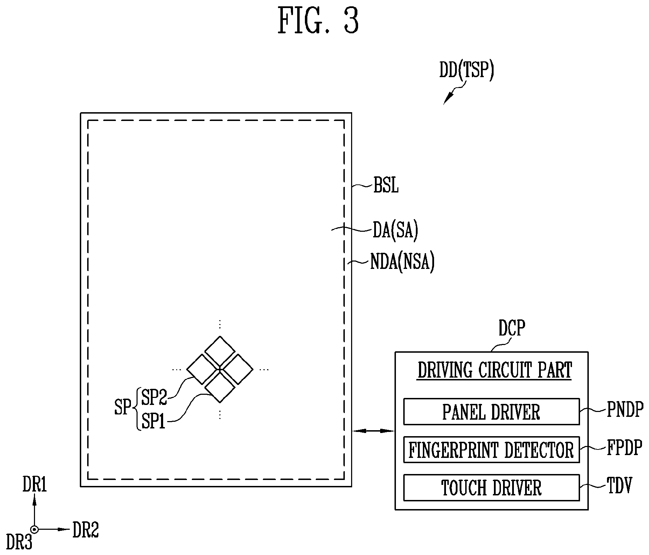

FIGS. 2 and 3 are schematic plan views illustrating the display device DD in accordance with one or more embodiments. FIG. 2 is a schematic plan view illustrating the display panel DP and a driving circuit part DCP included in the display device DD in accordance with one or more embodiments. FIG. 3 is a schematic plan view illustrating the touch sensor layer TSP and the driving circuit part DCP included in the display device DD in accordance with one or more embodiments.

For the sake of convenience in explanation, although FIGS. 2 and 3 illustrate that the driving circuit part DCP is shown separately from the display panel DP and the touch senor layer TSP, embodiments of the present disclosure are not limited thereto. In one or more embodiments, the entirety or a portion of the driving circuit part DCP may be implemented integrally with the display panel DP.

Referring to FIGS. 2 and 3, the display device DD may include a base layer BSL, and pixels PXL and sensing electrodes SP that are located on the base layer BSL. The display device DD may include the driving circuit part DCP. The driving circuit part DCP may include a panel driver PNDP, a fingerprint detector FPDP, and a touch driver TDV.

The base layer BSL may form a base surface of the display device DD. In one or more embodiments, the base layer BSL may be a bottom substrate for depositing layers of the display device DD. The base layer BSL may be a rigid, or may be a flexible substrate or film. For example, the base layer BSL may include glass material. Alternatively, the base layer BSL may include silicon material. As a further alternative, the base layer BSL may include polyimide. However, embodiments of the present disclosure are not limited to the aforementioned example.

A plane defined in this specification may extend in a first direction DR1 and a second direction DR2, and may be defined based on a plane on which the base layer BSL is located. In one or more embodiments, a third direction DR3 may correspond to a thickness direction of the base layer BSL. The third direction DR3 may correspond to a light output direction of the display device DD.

The display device DD (or the display panel DP) may include a display area DA in which the pixels PXL are located, and a non-display area NDA in which the pixel PXL is omitted. The non-display area NDA may enclose at least a portion of the display area DA. Various lines may be located in the non-display area NDA, pads may be located therein, and at least a portion of the driving circuit part DCP may be located therein.

The pixel PXL may include sub-pixels SPX. Two or more sub-pixels SPX may form a pixel PXL (or pixel unit).

In accordance with one or more embodiments, the pixels PXL (or the sub-pixels SPX) may be arranged in a stripe or PENTILE^{™} arrangement structure or the like, but embodiments of the present disclosure are not limited thereto (PENTILE^{™} being a registered trademark of Samsung Display Co., Ltd., Republic of Korea). Various pixel arrangements may be applied to embodiments of the present disclosure.

The display device DD may include a fingerprint-sensing area FA in which light-sensing pixels PSR are located. The fingerprint-sensing area FA may be an area that can sense a fingerprint input from the user. The fingerprint-sensing area FA may overlap the display area DA, in plan view. The fingerprint-sensing area FA may be inside the display area DA, and may partially enclose a portion of the display area DA. A range in which the fingerprint-sensing area FA is in the display device DD is not limited to any particular example.

In one or more embodiments, the fingerprint-sensing area FA may overlap the display area DA. Accordingly, the pixels PXL may also be located in the fingerprint-sensing area FA. Therefore, in one or more embodiments, a fingerprint of the user may be sensed in an area where an image is visible.

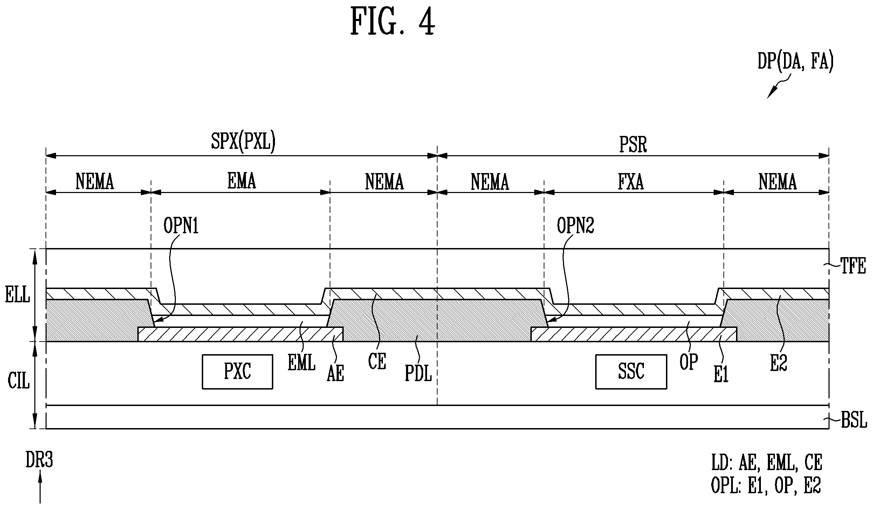

The light-sensing pixels PSR may sense that light, which is emitted from a light source (e.g., a light-emitting element LD as shown in FIG. 4), is reflected by an external object (e.g., the finger of the user). For example, each of the light-sensing pixels PSR may sense information about a fingerprint input from the user.

The driving circuit part DCP may drive the display panel DP. For example, the driving circuit part DCP may output a data signal corresponding to image data to the display panel DP, or may output driving signals for the light-sensing pixels PSR, and may receive electrical signals (e.g., sensing signals) from the light-sensing pixels PSR. The driving circuit part DCP may use the electrical signals to detect a fingerprint shape of the user.

The driving circuit part DCP may include the panel driver PNDP and the fingerprint detector FPDP (or a sensor driver). For the sake of convenience in explanation, FIGS. 2 and 3 illustrates the panel driver PNDP and the fingerprint detector FPDP separately, but embodiments of the present disclosure are not limited thereto. For instance, at least a portion of the fingerprint detector FPDP may be integrated with the panel driver PNDP, or may operate in conjunction with the panel driver PNDP.

The panel driver PNDP may sequentially scan the sub-pixels SPX in the display area DA, and may supply data signals corresponding to an image data signal to the sub-pixels SPX. In this case, the display panel DP may display an image corresponding to the image data.

The panel driver PNDP may supply driving signals for fingerprint-sensing to the sub-pixels SPX. The driving signals may be provided to cause the sub-pixels SPX to emit light, and may operate as a light source for fingerprint input sensing by the light-sensing pixels PSR. In one or more embodiments, the panel driver PNDP may also supply the driving signals and/or other driving signals for fingerprint-sensing to the light-sensing pixels PSR. However, embodiments of the present disclosure are not limited to the aforementioned example, and driving signals for fingerprint-sensing may be provided by the fingerprint detector FPDP.

The fingerprint detector FPDP may detect biometric information related to the fingerprint of the user or the like, based on sensing signals received from the light-sensing pixels PSR. In one or more embodiments, the fingerprint detector FPDP may supply the driving signals to the light-sensing pixels PSR and/or the sub-pixels SPX.

The driving circuit part DCP may drive the touch sensor layer TSP. For example, the touch driver TDV may supply sensing signals to the sensing electrodes SP, and may receive a user input signal obtained by sensing a touch input from the user. For example, the sensing electrodes SP may include a first sensing electrode SP1 extending in the first direction DR1 and a second sensing electrode SP2 extending in the second direction DR2. In one or more embodiments, one of the first and second sensing electrodes SP1 and SP2 may be a transmitter (Tx) pattern electrode, and the other may be a receiver (Rx) pattern electrode.

The sensing electrodes SP may sense a change in capacitance between the first and second sensing electrodes SP1 and SP2 as the user provide a touch input, and the touch driver TDV may determine a location of the user touch input based on the change in capacitance.

In one or more embodiments, the display area DA and the sensing area SA may overlap each other. Furthermore, the fingerprint-sensing area FA may overlap the sensing area SA. In one or more embodiments, the non-display area NDA and the non-sensing area NSA may overlap each other. Unless otherwise specified in the following description, the display area DA and the sensing area SA may be interpreted as being at corresponding positions.

A light-emitting element LD and a light-receiving element OPL in accordance with one or more embodiments will be described with reference to FIG. 4.

FIG. 4 is a schematic sectional view illustrating the display panel DP in accordance with one or more embodiments. FIG. 4 schematically illustrates a sectional structure of the display panel DP in the fingerprint-sensing area FA included in the display area DA.

Referring to FIG. 4, the display panel DP may include a light-emitting element LD included in the pixel PXL (or the sub-pixel SPX), and a light-receiving element OPL included in the light-sensing pixel PSR.

In one or more embodiments, the pixel PXL may include an emission area EMA, and a non-emission area NEMA adjacent to the emission area EMA. In one or more embodiments, the emission area EMA may be defined by a first opening OPN1 of a pixel-defining layer PDL in which an emission layer EML may be located. The emission area EMA may be an area where light is emitted from the emission layer EML.

In one or more embodiments, the light-sensing pixel PSR may include a light-receiving area FXA, and a non-emission area NEMA adjacent to the light-receiving area FXA. The light-receiving area FXA may be defined by a second opening OPN2 of the pixel-defining layer PDL in which a light-receiving layer OP may be located. The light-receiving area FXA may be an area where target light to be sensed is applied to the light-receiving layer OP.

In one or more embodiments, the display panel DP may include a circuit layer CIL including the base layer BSL, and an element layer ELL on the circuit layer CIL.

The circuit layer CIL may include the base layer BSL, and may include a pixel circuit PXC for driving the light-emitting element LD and a sensor circuit SSC for driving a light-receiving element OPL, which are placed on the base layer BSL. The circuit layer CIL may include a semiconductor layer, a conductive layer, and an insulating layer, which are provided to form the pixel circuit PXC and the sensor circuit SSC.

The element layer ELL may include the light-emitting element LD and the light-receiving element OPL, and may include the pixel-defining layer PDL and an encapsulation layer TFE that are adjacent to the light-emitting element LD and the light-receiving element OPL.

The light-emitting element LD may include an anode electrode AE, the emission layer EML, and a cathode electrode CE. The light-emitting element LD may be an organic light-emitting diode.

The anode electrode AE may be located on the circuit layer CIL, and may be electrically connected to the pixel circuit PXC. The pixel-defining layer PDL may cover a portion of the anode electrode AE while allowing a portion of an upper surface of the anode electrode AE to be exposed. The emission layer EML may be located on the anode electrode AE, and may include a hole transport component, an emission component, and an electron transport component. The cathode electrode CE may be located on the emission layer EML.

The light-receiving element OPL may include a first light-receiving electrode E1, a light-receiving layer OP, and a second light-receiving electrode E2. The light-receiving element OPL may be a photo diode. However, embodiments of the present disclosure are not limited to the foregoing example.

The light-receiving element OPL may be configured to obtain a sensing signal corresponding to light emitted from the light-emitting element LD. The light-receiving element OPL may sense light rays reflected by ridges of the fingerprint of the user, along with valleys between the ridges, when a fingerprint input is provided from the user, thereby recognizing the fingerprint. For example, if the finger of the user comes into contact with the window layer WD, light output from the light-emitting element LD may be reflected by the ridges and valleys of the fingerprint of the finger, and the reflected light may reach the light-receiving element OPL. The light-receiving element OPL may distinguish between light reflected from the ridges of the fingerprint of the finger and light reflected from the valleys of the fingerprint of the finger, thereby recognizing a pattern of the fingerprint of the user.

The first light-receiving electrode E1 may be located on the circuit layer CIL, and may be electrically connected to the sensor circuit SSC. The pixel-defining layer PDL may cover a portion of the first light-receiving electrode E1 while allowing a portion of an upper surface of the first light-receiving electrode E1 to be exposed. The light-receiving layer OP may be located on the first light-receiving electrode E1, and may include an electron-blocking layer and a light-receiving component. The second light-receiving electrode E2 may be located on the light-receiving layer OP.

In one or more embodiments, the cathode electrode CE and the second light-receiving electrode E2 may be patterned through a same process, and may be integrally formed. Each of the cathode electrode CE and the second light-receiving electrode E2 may include a thin metal layer or various transparent conductive materials. The anode electrode AE may include various conductive materials. The pixel-defining layer PDL may include organic material or inorganic material.

The encapsulation layer TFE may be located on the light-emitting element LD and the light-receiving element OPL, and may encapsulate the underlying layers. The encapsulation layer TFE may include an organic layer and/or an inorganic layer, but embodiments of the present disclosure are not limited to any particular example.

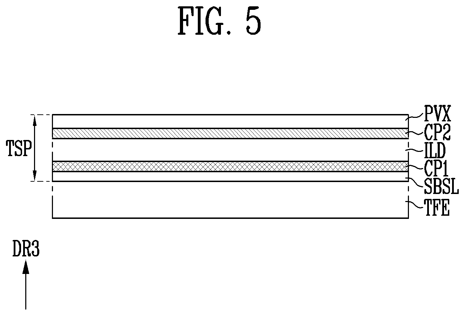

The touch sensor layer TSP in accordance with one or more embodiments will be described with reference to FIGS. 5 to 7.

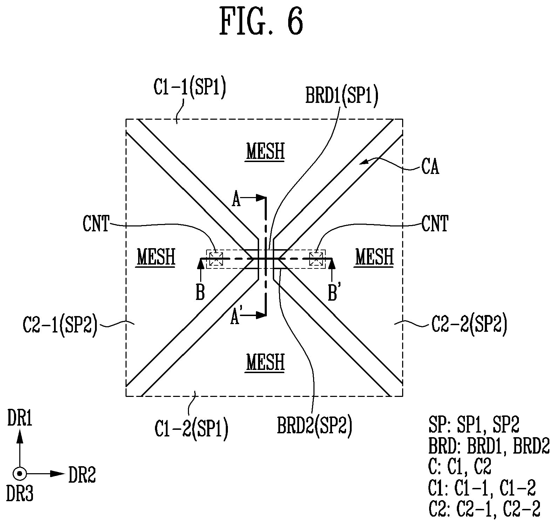

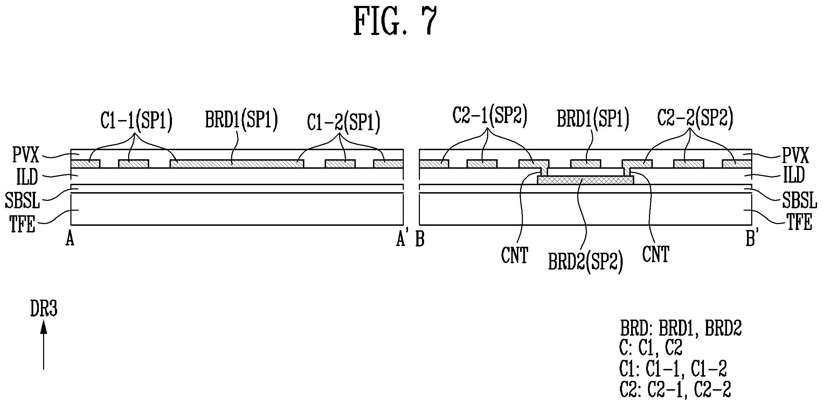

FIG. 5 is a schematic sectional view illustrating the touch sensor layer TSP in accordance with one or more embodiments. FIG. 6 is a schematic plan view illustrating sensing electrodes SP in accordance with one or more embodiments. FIG. 6 illustrates a schematic planar structure showing an area where a first sensing electrode SP1 and a second sensing electrode SP2 are adjacent to each other. FIG. 7 is a schematic sectional view illustrating the touch sensor layer TSP in accordance with one or more embodiments. FIG. 7 illustrates a schematic sectional structure taken along the line A-A' of FIG. 6, and a sectional structure taken along the line B-B' of FIG. 6.

Referring to FIGS. 5 to 7, the touch sensor layer TSP may be located (e.g., directly located) on the encapsulation layer TFE. The touch sensor layer TSP may include a sensor base layer SBSL, a first conductive pattern layer CP1, an intermediate insulating layer ILD, a second conductive pattern layer CP2, and a passivation layer PVX.

In one or more embodiments, the first conductive pattern layer CP1 and the second conductive pattern layer CP2 may be located on different layers. The first conductive pattern layer CP1 and the second conductive pattern layer CP2 may partially overlap each other in plan view.

In one or more embodiments, the first conductive pattern layer CP1 and the second conductive pattern layer CP2 may be patterned in one area to form the sensing electrodes SP. For example, at least a portion of each of the first conductive pattern layer CP1 and the second conductive pattern layer CP2, or the second conductive pattern layer CP2, may form the first sensing electrode SP1. At least a portion of each of the first conductive pattern layer CP1 and the second conductive pattern layer CP2, or the second conductive pattern layer CP2, may form the second sensing electrode SP2.

The sensor base layer SBSL may be located (e.g., directly located) on the encapsulation layer TFE. The sensor base layer SBSL may provide an area where the first conductive pattern layer CP1, the intermediate insulating layer ILD, the second conductive pattern layer CP2, and the passivation layer PVX are located.

The first conductive pattern layer CP1 may be located on the sensor base layer SBSL. The second conductive pattern layer CP2 may be located on the intermediate insulating layer ILD. The first conductive pattern layer CP1 and the second conductive pattern layer CP2 may be spaced apart from each other with the intermediate insulating layer ILD interposed therebetween.

Each of the first conductive pattern layer CP1 and the second conductive pattern layer CP2 may include a single metallic layer or multiple metallic layers. Each of the first conductive pattern layer CP1 and the second conductive pattern layer CP2 may include at least one of various metals including gold (Au), silver (Ag), aluminum (Al), molybdenum (Mo), chrome (Cr), titanium (Ti), nickel (Ni), neodymium (Nd), copper (Cu), platinum (Pt), or the like, or an alloy thereof. In one or more embodiments, the first conductive pattern layer CP1 and the second conductive pattern layer CP2 may include at least one of various transparent conductive materials including at least one among a silver nanowire (AgNW), indium tin oxide (ITO), indium zinc oxide (IZO), indium gallium zinc oxide (IGZO), aluminum zinc oxide (AZO), indium tin zinc oxide (ITZO), zinc oxide (ZnO), tin oxide (SnO₂), carbon nanotubes, or graphene.

The intermediate insulating layer ILD may be located on the first conductive pattern layer CP1. The intermediate insulating layer ILD may be interposed between the first conductive pattern layer CP1 and the second conductive pattern layer CP2. The passivation layer PVX may be located on the second conductive pattern layer CP2.

The sensor base layer SBSL may include one or more of inorganic material or organic material. The intermediate insulating layer ILD may include one or more of inorganic material or organic material. In embodiments, the passivation layer PVX may include organic material. The inorganic material may include one or more selected from the group consisting of silicon nitride (SiNₓ), silicon oxide (SiOₓ), silicon oxynitride (SiOₓN_{y}), or aluminum oxide (AlOₓ). The organic material may include one or more selected from the group consisting of acryl resin, epoxy resin, phenol resin, polyamide resin, or polyimide resin. However, embodiments of the present disclosure are not limited to the aforementioned example.

The cutting area CA may be an area formed by cutting at least one of the first conductive pattern layer CP1 or the second conductive pattern layer CP2. For example, the cutting area CA may be an area formed by cutting at least a portion of the second conductive pattern layer CP2 to electrically separate the first and second sensing electrodes SP1 and SP2 from each other. For example, the first and second sensing electrodes SP1 and SP2 may be adjacent to each other with the cutting area CA interposed therebetween, and may be physically spaced apart from each other.

The sensing electrodes SP may include cells C and bridges BRD. Each of the cell C may have a relatively large surface area. Each of the bridge BRD may have a relatively small surface area. The associated cells C adjacent to each other may be electrically connected to each other by the corresponding bridge BRD. The cells C may include a first cell C1 and a second cell C2. The bridges BRD may include a first bridge BRD1 and a second bridge BRD2.

In one or more embodiments, the first cell C1 and the second cell C2 may be a part of the second conductive pattern layer CP2. The first bridge BRD1 may be a part of the second conductive pattern layer CP2. A portion of the second bridge BRD2 may be a part of the first conductive pattern layer CP1. However, embodiments of the present disclosure are not limited to the foregoing example. For example, the first cell C1 and the second cell C2 may be a part of the first conductive pattern layer CP1. In one or more embodiments, the first bridge BRD1 may be a part of the first conductive pattern layer CP1. A portion of the second bridge BRD2 may be a part of the second conductive pattern layer CP2. The other portion of the second bridge BRD2 may be a part of the first conductive pattern layer CP1.

In one or more embodiments, the sensing electrodes SP may form a mesh structure MESH. The cells C and the bridges BRD may form a mesh structure MESH. For example, the second conductive pattern layer CP2 for forming the sensing electrodes SP may be patterned according to a mesh structure MESH.

The first sensing electrode SP1 may have a structure in which the first cells C1 each having a relatively large surface area and the first bridge BRD1 having a relatively small surface area are connected to each other. For example, the first cells C1 may include a 1-1-th cell C1-1 and a 1-2-th cell C1-2. The first bridge BRD1 may electrically connect the 1-1-th cell C1-1 and the 1-2-th cell C1-2 to each other.

The second sensing electrode SP2 may have a structure in which the second cells C2 each having a relatively large surface area, and the second bridge BRD2 having a relatively small surface area, are connected to each other. For example, the second cells C2 may include a 2-1-th cell C2-1 and a 2-2-th cell C2-2. The second bridge BRD2 may electrically connect the 2-1-th cell C2-1 and the 2-2-th cell C2-2 to each other.

In one or more embodiments, the second bridge BRD2 may be electrically connected to the 2-1-th cell C2-1 through a contactor CNT, and may be electrically connected to the 2-2-th cell C2-2 through another contactor CNT. Hence, the second bridge BRD2 that is located on a layer that is different from that of the second cell C2 may electrically connect the 2-1-th cell C2-1 and the 2-2-th cell C2-2 to each other through the contactor CNT. In one or more embodiments, the contactor CNT may pass through the intermediate insulating layer ILD.

The first cell C1 and the second cell C2 each may have a diamond shape. However, the shape of each of the first cell C1 and the second cell C2 is not particularly limited to the foregoing example.

In accordance with one or more embodiments, the cutting area CA may be defined between the sensing electrodes SP, which are electrically spaced apart from each other. For example, the first sensing electrodes SP1 and the second sensing electrodes SP2 may be adjacent to each other with the cutting area CA interposed therebetween. The cutting area CA may be defined in an area between the first sensing electrodes SP1 and the second sensing electrodes SP2. For example, the cutting area CA may be located (e.g., formed or defined) between the 1-1-th cell C1-1 and the second cell C2. The cutting area CA may be located (e.g., formed or defined) between the first bridge BRD1 and the second cell C2.

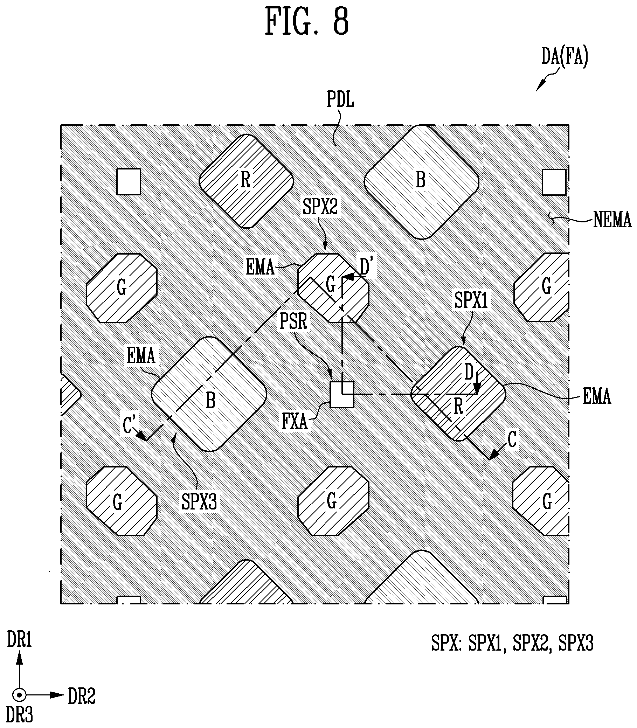

Hereinafter, the display device DD in accordance with one or more embodiments will be described with reference to FIGS. 8 to 16. For the sake of convenience in explanation, descriptions of content that overlap those of the embodiments described above will be simplified or omitted.

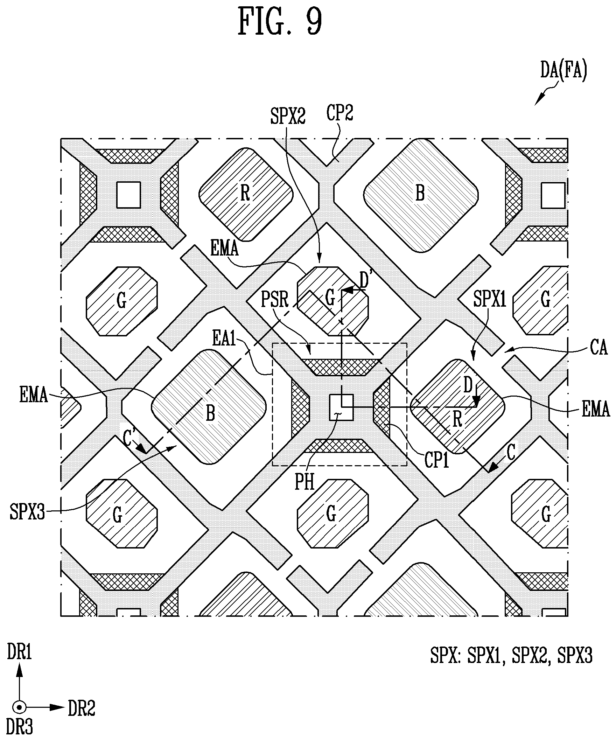

FIGS. 8 and 9 are schematic plan views illustrating a portion of the display area including the fingerprint-sensing area in the display device in accordance with one or more embodiments. FIGS. 8 and 9 illustrate a same area. Accordingly, the planar arrangement between the components of the display device DD will be clearly understood with reference to FIGS. 8 and 9.

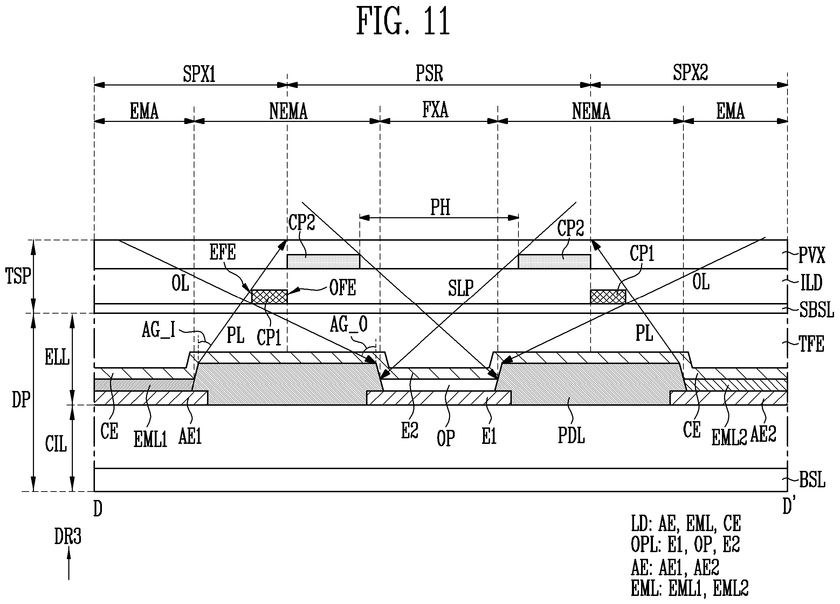

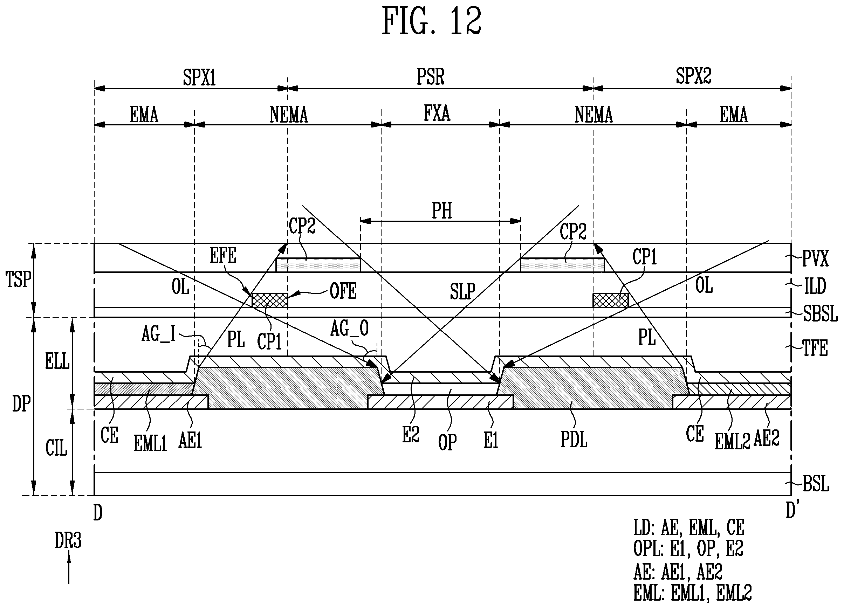

FIG. 10 is a schematic sectional view taken along the line C-C' of FIGS. 8 and 9. FIGS. 11 to 14 are schematic sectional views taken along the line D-D' of FIGS. 8 and 9. FIG. 11 illustrates a sectional structure of the display device DD in accordance with one or more embodiments. FIGS. 12 to 14 each illustrate a sectional structure of the display device DD having a structure that is partially different from that illustrated in FIG. 11.

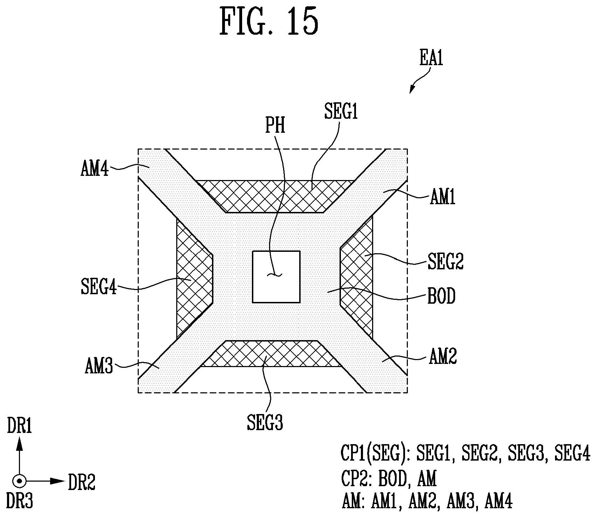

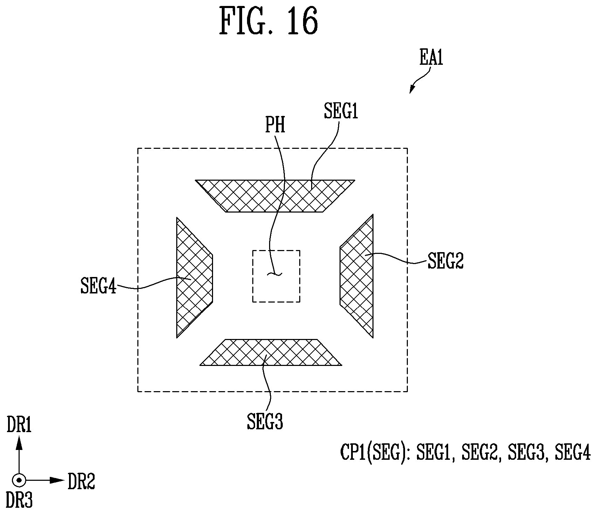

FIGS. 15 and 16 are schematic enlarged views of area EA1 of FIG. 9. FIGS. 15 and 16 illustrate a same area. FIG. 15 illustrates the first and second conductive pattern layers CP1 and CP2 and a hole area PH, while FIG. 16 illustrates the first conductive pattern layer CP1 and the hole area PH without illustrating the second conductive pattern layer CP2.

In one or more embodiments, the sub-pixels SPX may include a first sub-pixel SPX1, a second sub-pixel SPX2, and a third sub-pixel SPX3. The first sub-pixel SPX1 may provide light of a first color (e.g., red R). The second sub-pixel SPX2 may provide light of a second color (e.g., green G). The third sub-pixel SPX3 may provide light of a third color (e.g., blue B).

In one or more embodiments, FIGS. 8 and 9 illustrate the first to third sub-pixels SPX1 to SPX3 arranged in a PENTILE^{™} layout (PENTILE^{™} being a registered trademark of Samsung Display Co., Ltd., Republic of Korea). However, embodiments of the present disclosure are not limited to the aforementioned example.

In one or more embodiments, the location of each sub-pixel SPX may correspond to an emission area EMA where light emitted from the corresponding light-emitting element LD is provided. The location of each light-sensing pixel PSR may correspond to a light-receiving area FXA where the corresponding light-receiving element OPL receives light.

In one or more embodiments, because the fingerprint-sensing area FA is in the display area DA, light-receiving areas FXA and emission areas EMA may be arranged in a single area. For example, the first to third sub-pixels SPX1 to SPX3 may be located around a periphery of each light-receiving area FXA. Accordingly, light emitted from the light-emitting element LD may be provided from the emission area EMA, and based on this, the light reflected from the fingerprint of the user may be provided to the light-receiving area FXA of the light-sensing pixel PSR.

In one or more embodiments, based on the first and second openings OPN1 and OPN2 defined by the pixel-defining layer PDL, the emission areas EMA and the light-receiving areas FXA may be formed. Therefore, the pixel-defining layer PDL may be located in at least a portion of an area other than the emission areas EMA and the light-receiving areas FXA.

In one or more embodiments, the first conductive pattern layer CP1 and the second conductive pattern layer CP2 may be located around peripheries of the emission areas EMA and the light-receiving areas FXA. The first conductive pattern layer CP1 and the second conductive pattern layer CP2 may overlap the pixel-defining layer PDL in plan view.

In one or more embodiments, the first conductive pattern layer CP1 may be located around a periphery of the portion of the second conductive pattern layer CP2 that forms each hole area PH. The first conductive pattern layer CP1 may not overlap the hole area PH and the light-receiving area FXA.

In one or more embodiments, the first conductive pattern layer CP1 may be located between each emission area EMA and the corresponding light-receiving area FXA. The first conductive pattern layer CP1 may be located between each emission area EMA and the second conductive pattern layer CP2. For example, the first conductive pattern layer CP1 (for example, segments SEG in FIG. 15) may be located in each of the loop structures of the second conductive pattern layer CP2 that enclose the respective emission areas EMA.

In one or more embodiments, the second conductive pattern layer CP2 may have a mesh structure. The second conductive pattern layer CP2 may form a mesh structure around peripheries of the sub-pixels SPX and the light-sensing pixels PSR. The second conductive pattern layer CP2 may include cutting areas CA formed by cuts in at least some areas.

In one or more embodiments, the second conductive pattern layer CP2 may form hole areas PH. For example, the second conductive pattern layer CP2 may include hole areas PH that are openings overlapping the respective light-receiving areas FXA, in plan view.

Referring to FIG. 10, the touch sensor layer TSP may be located on the display panel DP. The color filter layer CFL and the window layer WD may be located on the touch sensor layer TSP.

The respective light-emitting elements LD of the first to third sub-pixels SPX1 to SPX3 may include the anode electrode AE including first to third anode electrodes AE1 to AE3, the emission layer EML including first to third emission layers EML1 to EML3, and the cathode electrode CE. The first to third emission layers EML1 to EML3 may respectively emit light of first to third colors.

The color filter layer CFL may include color filters CF and a light-blocking pattern layer LBP. The color filters CF may include a first color filter CF1 located in the first sub-pixel SPX1, a second color filter CF2 located in the second sub-pixel SPX2, and a third color filter CF3 located in the third sub-pixel SPX3.

The first color filter CF1 may include color filter material (e.g., pigment or dye) for allowing light of the first color (e.g., red) to selectively pass therethrough. The light of the first color provided from the light-emitting element LD of the first sub-pixel SPX1 may pass through the first color filter CF1, and may be emitted externally.

The second color filter CF2 may include color filter material (e.g., pigment or dye) for allowing light of the second color (e.g., green) to selectively pass therethrough. The light of the second color provided from the light-emitting element LD of the second sub-pixel SPX2 may pass through the second color filter CF2, and may be emitted externally.

The third color filter CF3 may include color filter material (e.g., pigment or dye) for allowing light of the third color (e.g., blue) to selectively pass therethrough. The light of the third color provided from the light-emitting element LD of the third sub-pixel SPX3 may pass through the third color filter CF3, and may be emitted externally.

In one or more embodiments, a non-emission area NEMA, where light of a certain color may not be visible, may be between the emission areas EMA. In one or more embodiments, in the non-emission area NEMA, the first color filter CF1, the second color filter CF2, and the third color filter CF3 may overlap each other in plan view, thereby forming a light-blocking pattern layer LBP.

Referring to FIGS. 11 to 14, a sectional structure of the display device DD including optical paths for the light-receiving element OPL to sense light is disclosed. FIGS. 11 to 14 illustrate a light-sensing pixel PSR and sub-pixels SPX adjacent thereto.

In one or more embodiments, light emitted from the light-emitting element LD may be provided to a front surface, and may be provided to the outside along a light output path PL. The light output path PL may have a first interfacial angle AG_I with respect to the thickness direction of the base layer BSL (e.g., the third direction DR3).

For the display device DD to have excellent viewing angle characteristics, light emitted from the light-emitting element LD may be sufficiently provided in a lateral direction. Accordingly, it may be appropriate for the light output path PL to be relatively wide (e.g., to have a relatively wide angle).

A range of the light output path PL may be defined by the first conductive pattern layer CP1. For example, light emitted from the light-emitting element LD may be provided to the front surface, and at least portion of the light emitted from the light-emitting element LD may be provided in the lateral direction.

The range of the light output path PL may be defined by an emission-facing end EFE of the first conductive pattern layer CP1. For example, in the case where the light output path PL is adjacent (e.g., directly adjacent) to the emission-facing end EFE of the first conductive pattern layer CP1, the first interfacial angle AG_I may have a maximum value.

In one or more embodiments, the range of the light output path PL may be defined (e.g., formed) by the first conductive pattern layer CP1 rather than the second conductive pattern layer CP2. In one or more embodiments, a portion of the second conductive pattern layer CP2 that forms the hole area PH may be spaced further apart from the light-emitting element LD compared to the first conductive pattern layer CP1. Experimentally, in the case where the second conductive pattern layer CP2 protrudes toward the emission area EMA, there is a risk that the light output path PL may be restricted, potentially reducing the viewing angle of the display device DD.

However, in accordance with one or more embodiments, the first conductive pattern layer CP1 that is adjacent to the light-emitting element LD at a relatively small height with respect to the base layer BSL may define the range of the light output path PL. Accordingly, the display device DD may have excellent viewing angle characteristics.

In one or more embodiments, external light may be applied from the outside into the display device DD along an external light path OL. The external light path OL may have a second interfacial angle AG_O with respect to the thickness direction of the base layer BSL (e.g., the third direction DR3).

In one or more embodiments, the second interfacial angle AG_O may be greater than the first interfacial angle AG_I.

To enhance the sensing sensitivity of the light-receiving element OPL, it may be suitable that external light or other light, rather than the light emitted from the light-emitting element LD, which is the target light to be sensed, not be applied to the light-receiving layer OP.

In one or more embodiments, the first conductive pattern layer CP1 may form an external light-blocking structure, thereby improving the sensing performance of the light-sensing pixel PSR.

The external light path OL directed toward the light-receiving layer OP may be substantially inclined. Here, the first conductive pattern layer CP1 may protrude toward the emission area EMA. The range of the external light path OL may be defined by the emission-facing end EFE of the first conductive pattern layer CP1. For example, in the case where the external light path OL is adjacent (e.g., directly adjacent) to the emission-facing end EFE of the first conductive pattern layer CP1, the second interfacial angle AG_O may have a maximum value.

In one or more embodiments, the range of the external light path OL may be defined (e.g., formed) by the first conductive pattern layer CP1 rather than the second conductive pattern layer CP2. In one or more embodiments, the second conductive pattern layer CP2 may be spaced further apart from the light-emitting element LD compared to the first conductive pattern layer CP1. Accordingly, in the case where the second conductive pattern layer CP2 protrudes toward the emission area EMA, there is a risk that not only the external light path OL, but also the light output path PL, may be restricted, potentially reducing the viewing angle of the display device DD.

However, in accordance with one or more embodiments, the first conductive pattern layer CP1 that is adjacent to the light-emitting element LD at a relatively small height with respect to the base layer BSL may define the range of the external light path OL. Accordingly, the display device DD may have excellent viewing angle characteristics, and the sensing performance of the light-sensing pixel PSR can be improved.

In one or more embodiments, the first conductive pattern layer CP1 may form both the external light-blocking structure for improving the sensing performance of the light-sensing pixel PSR, and a structure for improving the viewing angle characteristics of the sub-pixel SPX.

In one or more embodiments, light sensed by the light-receiving element OPL may be applied to the light-receiving layer OP along a light-receiving path SLP. In one or more embodiments, in the case where a fingerprint input from the user is applied to the display device DD (or the window layer WD), light emitted from the light-emitting element LD may be provided to the finger of the user along the light output path PL, and light reflected by the finger may be provided to the light-receiving layer OP along the light-receiving path SLP.

In one or more embodiments, the light reflected by the finger may be provided to the light-receiving layer OP through the hole area PH formed by the second conductive pattern layer CP2. A light recognition range of the light-receiving element OPL may be defined by the size of the hole area PH.

In one or more embodiments, at least a portion of the second conductive pattern layer CP2 may function as the sensing electrode SP, as described above. Another portion of the second conductive pattern layer CP2 may be located around the periphery of the light-receiving area FXA, thereby forming the hole area PH.

In one or more embodiments, the hole area PH may cover an area that is wider than the light-receiving area FXA in plan view. The hole area PH may overlap the light-receiving layer OP in plan view, and may also overlap a portion of the pixel-defining layer PDL.

Referring to FIG. 11, in one or more embodiments, the ends of the first conductive pattern layer CP1 that defines the external light path OL and the light output path PL, and the ends of the second conductive pattern layer CP2 that defines the light-receiving path SLP, may be substantially adjacent to each other in plan view, but might not overlap each other.

In one or more embodiments, the second conductive pattern layer CP2 may float. The second conductive pattern layer CP2 may not be electrically connected to other conductive structures.

An optical-facing end OFE of the first conductive pattern layer CP1 may be aligned with one end of the second conductive pattern layer CP2 in plan view. The first conductive pattern layer CP1 and the second conductive pattern layer CP2 may not include surfaces overlapping each other in plan view.

In this case, because a portion of the second conductive pattern layer CP2 may form the sensing electrode SP, a risk of unintended capacitance between the second conductive pattern layer CP2 and the first conductive pattern layer CP1 can be reduced.

Referring to FIG. 12 together, in one or more embodiments, the first conductive pattern layer CP1 and the second conductive pattern layer CP2 may overlap each other in plan view, and may be electrically separated from each other.

For example, the optical-facing end OFE of the first conductive pattern layer CP1 may overlap the second conductive pattern layer CP2 in plan view. At least a portion of the second conductive pattern layer CP2 may protrude toward the emission area EMA, and may not overlap the light output path PL defined by the first conductive pattern layer CP1. Accordingly, the light output path PL may be appropriately specified, and a process margin for forming the second conductive pattern layer CP2 may be ensured.

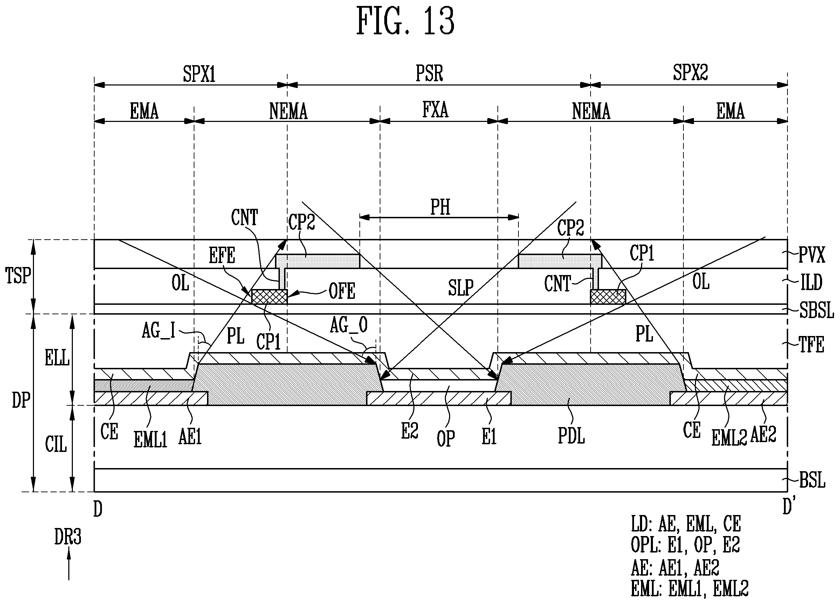

Referring to FIG. 13 together, in one or more embodiments, the first conductive pattern layer CP1 and the second conductive pattern layer CP2 may overlap each other in plan view, and may be electrically connected to each other.

In one or more embodiments, the second conductive pattern layer CP2 and the first conductive pattern layer CP1 may be electrically connected to each other through a contactor CNT between the emission area EMA and the light-receiving area FXA. In this case, even in the case where the first conductive pattern layer CP1 and the second conductive pattern layer CP2 overlap each other, the risk of unintended capacitance between the first conductive pattern layer CP1 and the second conductive pattern layer CP2 may be reduced.

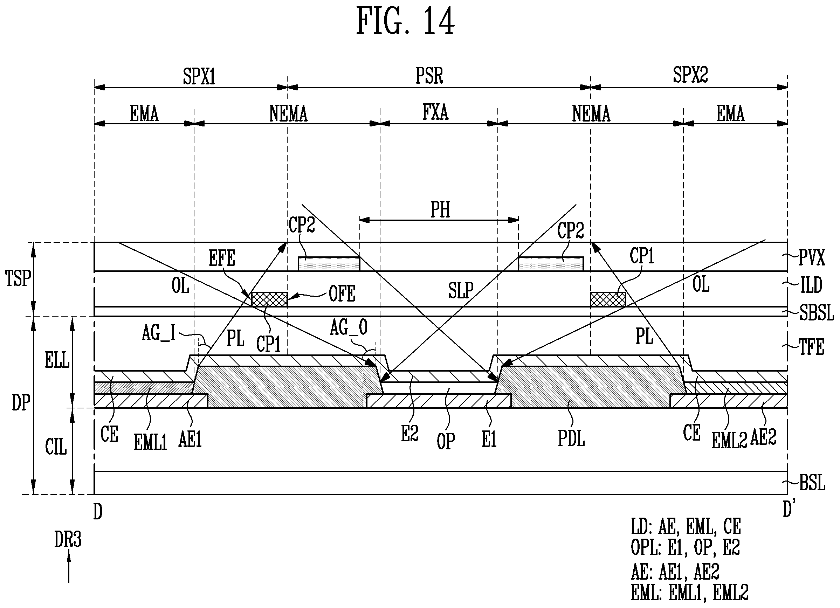

Referring to FIG. 14 together, in one or more embodiments, the first conductive pattern layer CP1 and the second conductive pattern layer CP2 may be spaced apart from each other in plan view.

In one or more embodiments, the first conductive pattern layer CP1 and the second conductive pattern layer CP2 may not overlap each other in plan view. Because the first conductive pattern layer CP1 and the second conductive pattern layer CP2 are spaced apart from each other by a relatively small distance in the thickness direction of the base layer BSL (e.g., the third direction DR3), a risk of forming the external light path OL between the first conductive pattern layer CP1 and the second conductive pattern layer CP2 may be reduced. Accordingly, while the risk of forming capacitance between the first conductive pattern layer CP1 and the second conductive pattern layer CP2 is reduced due to the separation therebetween, a process margin may be ensured during a process of fabricating the first conductive pattern layer CP1 and the second conductive pattern layer CP2.

Referring to FIGS. 15 and 16, there is illustrated a planar structure between the first conductive pattern layer CP1 and the second conductive pattern layer CP2 in accordance with one or more embodiments.

In one or more embodiments, the second conductive pattern layer CP2 may form a mesh structure for forming the sensing electrode SP, and may form the hole area PH for defining the light-receiving path SLP. To this end, the second conductive pattern layer CP2 may include a body portion BOD, and arm portions AM that are integral with the body portion BOD and that extend in two or more directions.

For example, the body portion BOD may include an opening, forming the hole area PH. The body portion BOD may enclose the light-receiving element OPL. Each of the arm portions AM may extend from at least one side of the body portion BOD in one direction. In one or more embodiments, the multiple arm portions AM may be provided. For example, the arm portions AM may include a first arm portion AM1 extending in a first extension direction, a second arm portion AM2 extending in a second extension direction, a third arm portion AM3 extending in a third extension direction, and a fourth arm portion AM4 extending in a fourth extension direction.

In one or more embodiments, the body portion BOD may have a width that is greater than each arm portion AM. In this case, the external light path OL may be between the second conductive pattern layer CP2 and the first conductive pattern layer CP1, thereby reducing a risk of applying external light to the light-receiving layer OP.

In one or more embodiments, the first conductive pattern layer CP1 may be around a periphery of the hole area PH (e.g., in plan view), and may be patterned to avoid overlap with the second conductive pattern layer CP2. Accordingly, the first conducive pattern layer CP1 may include segments SEG spaced apart from each other. For example, based on the hole area PH, the segments SEG may include a first segment SEG1 located on a first side of the hole area PH, a second segment SEG2 located on a second side of the hole area PH, a third segment SEG3 located on a third side of the hole area PH, and a fourth segment SEG4 located on a fourth side of the hole area PH.

In one or more embodiments, each of the segments SEG may float (e.g., electrically float).

In one or more embodiments, the segments SEG may be spaced apart from each other, and each may have an isolated form, for example, the segments SEG may comprise electrically floating isolated portions. In one or more embodiments, each of the segments SEG may be located between corresponding ones of the arm portions AM. Each of the segments SEG may be adjacent to the body portion BOD.

In one or more embodiments, the first conductive pattern layer CP1 may include segments SEG spaced apart from each other, thereby forming a structure in which the first and second conductive patterns layer CP1 and CP2 do not overlap each other. As a result, the light output path PL may be relatively wide, and the external light path OL may be blocked. Consequently, the sensing performance of the light-sensing pixel PSR may be enhanced, and a risk of electrical signal interference with respect to the sensing electrodes SP may be reduced, thereby further improving touch sensitivity.

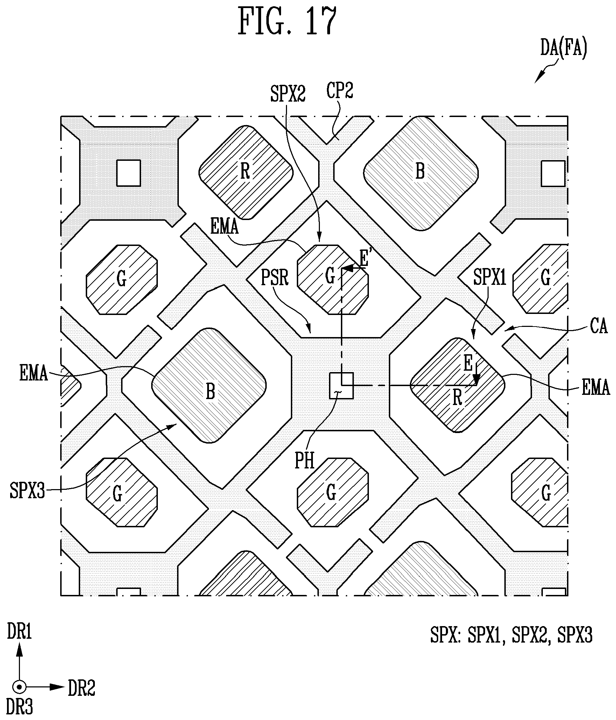

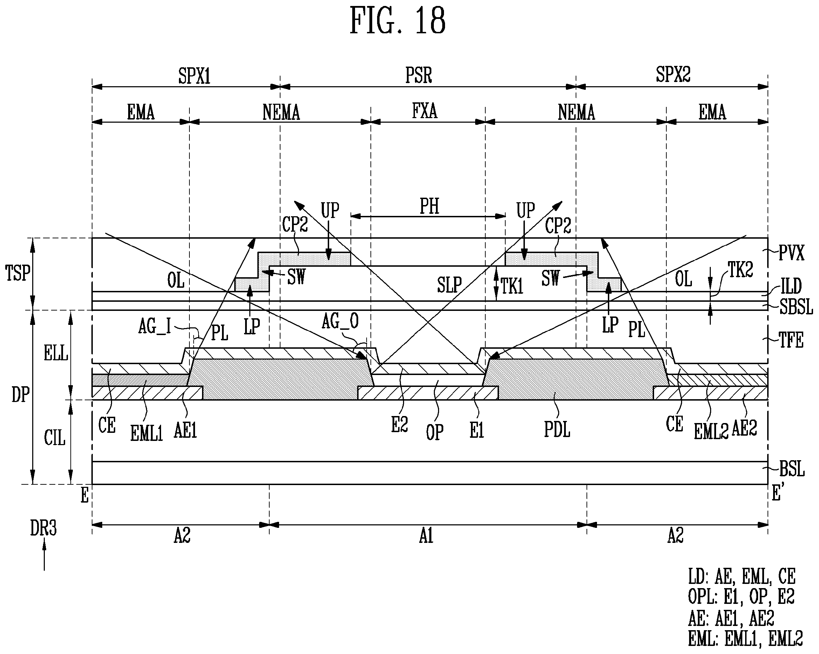

Hereinafter, a display device DD in accordance with one or more other embodiments will be described with reference to FIGS. 17 and 18. For the sake of convenience in explanation, descriptions of content that overlap those of the embodiments described above will be simplified or omitted.

FIG. 17 is a schematic plan view illustrating a portion of a display area including a fingerprint-sensing area in the display device in accordance with one or more embodiments. FIG. 18 is a schematic sectional view taken along the line E-E' of FIG. 17.

Referring to FIGS. 17 and 18, the second conductive pattern layer CP2 may form a sidewall SW around the periphery of the hole area PH, and the first conductive pattern layer CP1 may not be patterned around the periphery of the hole area PH.

In one or more embodiments, the sidewall SW that is at least a portion of the second conductive pattern layer CP2 may extend in a direction that is different from the extension direction of the plane on which the base layer BSL is located.

The intermediate insulating layer ILD may have different respective thicknesses in different areas. For example, the intermediate insulating layer ILD may have a first thickness TK1 in a first area A1, and a second thickness TK2 that is less than the first thickness TK1 in a second area A2.

In one or more embodiments, the first area A1 may cover the light-sensing pixel PSR (e.g., the light-receiving layer OP). The hole area PH may be included in an overall area of the first area A1 in plan view. The second area A2 may cover an area adjacent to the light-sensing pixel PSR.

In one or more embodiments, the intermediate insulating layer ILD may be patterned using a mask including a halftone portion and a full-tone portion, allowing the intermediate insulating layer ILD to be fabricated with different thicknesses in different areas.

In one or more embodiments, the second conductive pattern layer CP2 may be located across the first area A1 and the second area A2. Hence, the second conductive pattern layer CP2 may cover a stepped portion formed by the intermediate insulating layer ILD having the first thickness TK1 and the second thickness TK2. Hence, the sidewall SW that is a portion of the second conductive pattern layer CP2 may face the light-receiving area FXA.

In one or more embodiments, a portion of the second conductive pattern layer CP2, as a lower component LP, may be located on a portion of the intermediate insulating layer ILD having the second thickness TK2. A portion of the second conductive pattern layer CP2, as an upper component UP, may be located on another portion of the intermediate insulating layer ILD having the first thickness TK1. In one or more embodiments, the sidewall SW may be located between the upper component UP and the lower component LP.

In one or more embodiments, because the light output path PL and the external light path OL are defined by the lower component LP formed at a relatively low height, the display device DD may have wide viewing angle characteristics, and the risk of applying external light to the light-receiving layer OP may be reduced. Furthermore, because the upper component UP formed at a relatively high height does not excessively protrude toward the emission area EMA, the risk of degrading the viewing angle characteristics may be reduced. In addition, because of the presence of the sidewall SW, the risk of applying external light to the light-receiving layer OP may be further reduced.

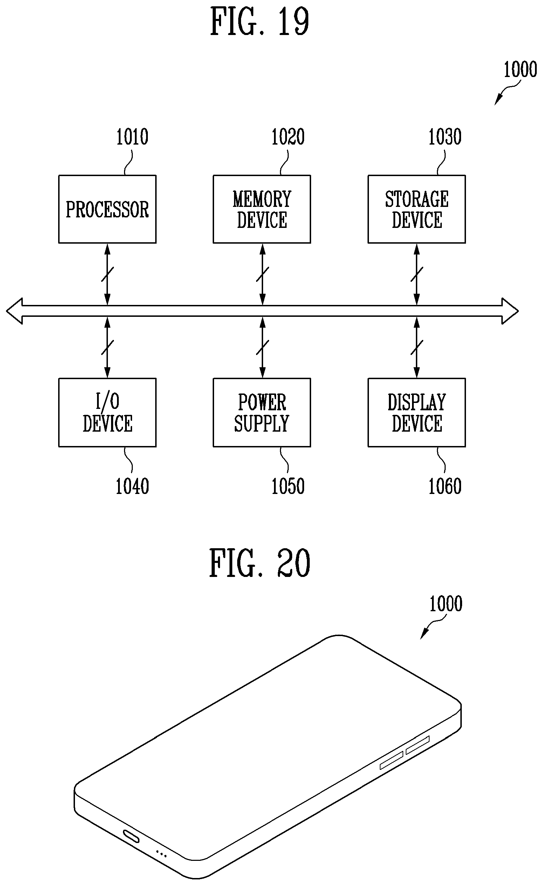

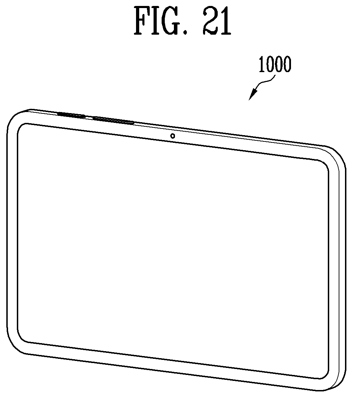

FIG. 19 is a schematic block diagram illustrating an electronic device 1000 including a display device in accordance with one or more embodiments. FIG. 20 is a schematic diagram illustrating an example where the electronic device 1000 of FIG. 19 is implemented as a smartphone. FIG. 21 is a schematic diagram illustrating an example where the electronic device 1000 of FIG. 19 is implemented as a tablet PC.

Referring to FIGS. 19 to 21, the electronic device 1000 may include a processor 1010, a memory device 1020, a storage device 1030, an input/output (I/O) device 1040, a power supply 1050, and a display device 1060. The display device 1060 may be the display device DD described above. The electronic device 1000 may further include various ports for communication with a video card, a sound card, a memory card, a USB device, or other systems. In one or more embodiments, as illustrated in FIG. 20, the electronic device 1000 may be implemented as a smartphone. In one or more embodiments, as illustrated in FIG. 21, the electronic device 1000 may be implemented as a tablet PC. However, the aforementioned examples are illustrative, and the electronic device 1000 is not limited to the aforementioned examples. For example, the electronic device 1000 may be implemented as a cellular phone, a video phone, a smartpad, a smartwatch, a navigation device for vehicles, a computer monitor, a laptop computer, a head-mounted display device, or the like.

The processor 1010 may perform corresponding calculations or tasks. In one or more embodiments, the processor 1010 may be a microprocessor, a central processing unit, an application processor, or the like. The processor 1010 may be connected to other components through an address bus, a control bus, a data bus, and the like. In one or more embodiments, the processor 1010 may be connected to an expansion bus, such as a peripheral component interconnect (PCI) bus. In one or more embodiments, the processor 1010 may provide input image data to the display device 1060. Hence, the display device 1060 may display an image based on the input image data provided from the processor 1010.

The memory device 1020 may store data suitable to perform the operation of the electronic device 1000. For example, the memory device 1020 may include nonvolatile memory devices, such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, and a ferroelectric random access memory (FRAM) device, and/or volatile memory devices, such as a dynamic random access memory (DRAM) device, a static random access memory (SRAM) device, a mobile DRAM device, and so on.

The storage device 1030 may include a solid state drive (SSD), a hard disk drive (HDD), a CD-ROM, or the like.

The I/O device 1040 may include input devices, such as a keyboard, a keypad, a touchpad, a touch screen, and a mouse, and output devices, such as a speaker and a printer. In one or more embodiments, the display device 1060 may be included in the I/O device 1040.

The power supply 1050 may supply power suitable to perform the operation of the electronic device 1000. For example, the power supply 1050 may be a power management integrated circuit (PMIC). In one or more embodiments, the power supply 1050 may supply power to the display device 1060.

The display device 1060 may display an image corresponding to visual information of the electronic device 1000. The display device 1060 may be connected to other components through the buses or other communication links.

As discussed, embodiments can provide a display device comprising: a sub-pixel above a base layer, the sub-pixel comprising a light-emitting element; a light-sensing pixel above the base layer, the light-sensing pixel comprising a light-receiving element configured to acquire a sensing signal corresponding to light emitted from the light-emitting element; and a touch sensor layer configured to acquire information about a touch input, the touch sensor layer comprising a conductive pattern layer forming sensing electrodes and comprising: a second conductive pattern layer comprising a body portion enclosing the light-receiving element in plan view, and arm portions extending from the body portion in respective directions; and a first conductive pattern layer in a different layer from the second conductive pattern layer, and comprising segments apart from each other in respective areas between respective ones of the arm portions in plan view.

Embodiments can also provide a display device comprising: a sub-pixel above a base layer, the sub-pixel comprising a light-emitting element; a light-sensing pixel above the base layer, the light-sensing pixel comprising a light-receiving element configured to acquire a sensing signal corresponding to light emitted from the light-emitting element; and a touch sensor layer configured to acquire information about a touch input, the touch sensor layer comprising a conductive pattern layer forming sensing electrodes and comprising: a first conductive pattern layer; a second conductive pattern layer having a portion forming a hole area overlapping the light-receiving element, and another portion forming a sidewall; and an intermediate insulating layer between the first conductive pattern layer and the second conductive pattern layer, the intermediate insulating layer having a first thickness in a first area that overlaps the hole area, and a second thickness that is less than the first thickness in a second area, wherein the sidewall is between the first area and the second area.

Embodiments can also provide an electronic device comprising: a processor configured to provide input image data; a power supply configured to supply power;a display device configured to receive the power, and to display an image based on the input image data, the display device being according to of the above mentioned embodiments.

Various embodiments of the present disclosure may provide a display device and an electronic device including the display device, in which light-sensing pixels can have improved light-sensing performance, thereby making it possible to clearly detect external inputs.

Various embodiments of the present disclosure may provide a display device with improved viewing angle characteristics, and an electronic device including the display device.

Various embodiments of the present disclosure may provide a display device with improved touch sensitivity, and an electronic device including the display device.

While various embodiments have been described above, those skilled in the art will appreciate that various modifications, additions and substitutions are possible, without departing from the scope of the present disclosure.

Therefore, the embodiments disclosed in this specification are only for illustrative purposes rather than limiting the present disclosure. The scope of the present disclosure must be defined by the accompanying claims, with functional equivalents thereof to be included therein.

## Claims

1. A display device comprising:
a sub-pixel above a base layer, the sub-pixel comprising a light-emitting element;
a light-sensing pixel above the base layer, the light-sensing pixel comprising a light-receiving element configured to acquire a sensing signal corresponding to light emitted from the light-emitting element; and
a touch sensor layer configured to acquire information about a touch input, the touch sensor layer comprising a conductive pattern layer forming sensing electrodes and comprising:
a second conductive pattern layer comprising a body portion enclosing the light-receiving element in plan view, and arm portions extending from the body portion in respective directions; and
a first conductive pattern layer in a different layer from the second conductive pattern layer, and comprising segments apart from each other in respective areas between respective ones of the arm portions in plan view.

2. **The** display device of claim 1, further comprising:
a sensing area with the sensing electrodes therein;
a display area with the sub-pixel therein, comprising an emission area, and overlapping the sensing area; and
a fingerprint-sensing area with the light-sensing pixel therein, comprising a light-receiving area, and overlapping the display area,
wherein the second conductive pattern layer comprises a hole area overlapping the light-receiving area, and
wherein the segments are around a periphery of the second conductive pattern layer, and are apart from the hole area and the light-receiving area in plan view.

3. The display device of claim 2, wherein one of the segments is between the emission area and the second conductive pattern layer in plan view, and is in a loop structure of the second conductive pattern layer that encloses the emission area.

4. The display device of claim 2 or 3, wherein the first conductive pattern layer comprises:
an emission-facing end facing the emission area, and defining a range of a light output path of light emitted from the light-emitting element; and
an optical-facing end facing the light-receiving area,
wherein the emission-facing end defines a range of an external light path for external light applied from outside of the display device.

5. The display device of claim 4, wherein the light output path has a first interfacial angle with respect to a thickness direction of the base layer that has a maximum value when the light output path is directly adjacent to the emission-facing end,
wherein the external light path has a second interfacial angle with respect to the thickness direction that has a maximum value when the external light path is directly adjacent to the emission-facing end, and
wherein the second interfacial angle is greater than the first interfacial angle.

6. The display device of claim 4 or 5, wherein the optical-facing end and the second conductive pattern layer are apart in plan view, and
wherein the optical-facing end and one end of the second conductive pattern layer are aligned.

7. The display device of any one of claims 4 to 6, wherein the first conductive pattern layer and the second conductive pattern layer overlap, and are electrically insulated from each other.

8. The display device of any one of claims 4 to 6, wherein the first conductive pattern layer and the second conductive pattern layer overlap, and are electrically connected to each other.

9. The display device of any one of claims 4 to 6, wherein the first conductive pattern layer and the second conductive pattern layer are apart in plan view.

10. The display device of any one of claims 1 to 9, wherein the segments comprise electrically floating isolated portions.

11. The display device of any one of claims 1 to 10, wherein the light-receiving element comprises a light-receiving layer,
wherein the light-emitting element comprises an emission layer,
wherein the touch sensor layer comprises:
a sensor base layer comprising a base with the first conductive pattern layer thereabove; and
an intermediate insulating layer between the first conductive pattern layer and the second conductive pattern layer,
wherein the display device further comprises:
a pixel-defining layer covering a portion of the light-receiving layer and a portion of the emission layer; and
an encapsulation layer covering the light-receiving element and the light-emitting element, with the sensor base layer directly thereon.

12. A display device comprising:
a sub-pixel above a base layer, the sub-pixel comprising a light-emitting element;
a light-sensing pixel above the base layer, the light-sensing pixel comprising a light-receiving element configured to acquire a sensing signal corresponding to light emitted from the light-emitting element; and
a touch sensor layer configured to acquire information about a touch input, the touch sensor layer comprising a conductive pattern layer forming sensing electrodes and comprising:
a first conductive pattern layer;
a second conductive pattern layer having a portion forming a hole area overlapping the light-receiving element, and another portion forming a sidewall; and
an intermediate insulating layer between the first conductive pattern layer and the second conductive pattern layer, the intermediate insulating layer having a first thickness in a first area that overlaps the hole area, and a second thickness that is less than the first thickness in a second area,
wherein the sidewall is between the first area and the second area.

13. The display device of claim 12, wherein the first conductive pattern layer is not around a periphery of the hole area.

14. The display device of claim 12 or 13, wherein the second conductive pattern layer comprises:
an upper component above the intermediate insulating layer having the first thickness in the first area; and
a lower component above the intermediate insulating layer having the second thickness in the second area, and
wherein the sidewall is between the lower component and the upper component.

15. An electronic device comprising:
a processor configured to provide input image data;
a power supply configured to supply power;
a display device configured to receive the power, and to display an image based on the input image data, the display device being according to any one of claims 1 to 14.
